# EUROPEAN PATENT SPECIFICATION

(11) **EP 4 152 461 B1**
(45) Date of publication and mention of the grant of the patent: **01.07.2026**
(21) Application number: 22194891.2
(22) Date of filing: 09.09.2022
(51) Int. Cl.: H01M 10/0525, H01M 10/42, H01M 10/48, G01R 31/385, H02J 7/65, H01M 10/34, H01G 11/82, H01G 11/14, H02H 7/18

(54) **ASSEMBLED BATTERY TESTING METHOD**
PRÜFVERFAHREN FÜR ZUSAMMENGESETZTE BATTERIEN
PROCÉDÉ DE TEST DE BATTERIE ASSEMBLÉE

(30) Priority: 17.09.2021 JP 2021152471
(43) Date of publication of application: 22.03.2023
(73) Proprietor: Prime Planet Energy & Solutions, Inc., Tokyo 103-0022 (JP)
(72) Inventor: MAEDA, Reizo, Tokyo 103-0022 (JP)
(74) Representative: Kuhnen & Wacker Patent- und Rechtsanwaltsbüro PartG mbB

(56) References cited:
- EP-A1- 3 840 083
- JP-A- 2003 134 675
- US-A1- 2018 172 772
- US-A1- 2020 287 251
- US-B1- 10 895 606

## Description

### BACKGROUND

### 1. Technical Field

The present disclosure relates to an assembled battery testing method. Specifically, the present disclosure relates to a method of testing thermal propagation in an assembled battery including multiple single batteries.

### 2. Description of the Related Art

Secondary batteries such as lithium-ion secondary batteries and nickel hydride batteries are widely used in various fields. In fields where high-output power source such as a power source for vehicles are required, an assembled battery including multiple secondary batteries is used. In the assembled battery, multiple secondary batteries (hereinafter, also referred to as "single batteries") are arranged adjacent to each other generally. The single batteries aligned are electrically connected to each other via connection members.

Secondary batteries (single batteries) may generate heat due to damage to constituent members (especially separators) of the electrode body and excessive charging/discharging. When one single battery in the assembled battery with this configuration generates heat, the adjacent single batteries are heated, thereby accelerating the heat generation of the adjacent single batteries. If this accelerated heat generation due to heat transfer between the single batteries occurs in a chain reaction, the entire assembled battery may become very hot. In order to prevent the increase in temperature of the entire assembled battery due to the progression of such thermal propagation, a technique of detecting the thermal propagation in an early stage has been proposed. For example, JP 2021-12793 proposes a technique of detecting thermal propagation based on changes of voltages of the single batteries. In this technology described in JP 2021-12793, it is determined that the thermal propagation is occurring when, after detection of steep voltage drop in one battery cell (single battery), a steep voltage drop is detected in at least one of the other battery cells within the first time. Here, the "steep voltage drop" in the technology described in JP2021-12793 means that the voltage of the battery cell drops to around 0 V in a relatively short time.

Further, patent document US 10 895 606 B1 discloses a method for testing an internal short circuits in an electrochemical cell. A transistor is implanted in the cell, and it is electrically connected to a controllable voltage source. The transistor is joined between positive and negative components of the cell. The transistor is maintained at high resistance before start of testing. The voltage source is used to reduce electrical resistance in the transistor to simulate an internal short circuit in the electrochemical cell. Thermal runaway propagation in the cell is measured.

Patent document EP 3 840 083 A1 discloses a thermal runaway detection system that comprises a venting device with a sealing body which is disposed in a venting passage. Therein, the sealing body is configured to close the venting passage in a first position and is configured to open the venting passage in a second position. The thermal runaway detection system further comprises a thermal runaway detection circuit that is configured for monitoring a position of the sealing body and for outputting a signal corresponding to the position. Preferably, the thermal runaway detection circuit comprises a first detection node connected to the venting device and a second detection node connected to the venting device, wherein a conductible path between the first detection node and the second detection node is set conductive via the sealing body in one of the first position and the second position, and a controller configured to detect the conductivity of the conductible path and also configured to output a signal corresponding to the conductivity of the conductible path.

Patent document US 2020/287251 A1 discloses an inspection device which includes a charging unit and an inspection unit, and detects the connection anomaly by retrieving a first cell voltage at the early stage of start of the constant-current charging and a second cell voltage at a stage where the charging has progressed to determine deviations from the average value of all the cell groups. A cell group in which the deviation of the first cell voltage is small and the deviation of the second cell voltage is large is judged to have a parallel connection anomaly. If the deviations are both large and equal to each other, it is judged as a cell group having a series connection anomaly.

In addition, patent document JP 2003 134675 A discloses that voltages of cells are detected with differential amplifier parts, respectively, and a total voltage of a module cell comprising the cells is detected with a total voltage detecting circuit. At fault examination, (1) the total voltage detecting circuit is determined to be abnormal if the absolute value of the difference between the total voltage and the total sum exceeds a threshold, a differential amplifier part is determined to be abnormal if the absolute value of the difference between a cell voltage and average voltage is larger than a first voltage threshold while equal to or less than a second voltage threshold, (3) a cell is determined to be abnormal if the absolute value of the difference between the cell voltage and the average voltage is larger than the second voltage threshold.

Moreover, patent document US 2018/172772 A1 discloses an online detection method for internal short-circuit of power battery, which comprises the following steps: in the process of charging and discharging, when the state of charge of a power battery is greater than a preset first threshold, monitoring and recording the voltage for each cell in the power battery; in accordance with the recorded historical voltages of each cell, determining whether there is a cell with voltage less than a second threshold in the process of charging, and less than a third threshold in the process of discharging, if so, then marking the corresponding cell as an internal short-circuited cell.

### SUMMARY

The increasing demand for safety in recent years has led to a need for a technology that can more accurately detect thermal propagation in an earlier stage than the technology described in JP 2021-12793. Specifically, as mentioned above, in this technology described in JP 2021-12793, it is determined that the thermal propagation is occurring when a steep voltage drop (a voltage drop to around 0 V) occurs in a specific single battery, and then a steep voltage drop (a voltage drop to around 0 V) occurs in another single battery before a first time elapses. However, the heating itself of the single battery occurs before the voltage drops to around 0 V. This may progress the thermal propagation before measurement of the first time. In addition, with the technology described in JP 2021-12793, the thermal propagation is not detected until voltages of the other single batteries drop to around 0 V. Therefore, by the time point when thermal propagation occurring is detected, the thermal propagation may have progressed to the level that is difficult to deal with.

As a means of detecting thermal propagation in an earlier stage, it is considered to set the voltage value (hereinafter, referred to as a "reference voltage value") to be a determination criteria for determining whether or not a single battery is generating heat to be a value higher than around 0 V. However, when the reference voltage value is set to be a high value, changes in voltage during normal charging/discharging reaction may cause a single battery with a voltage lower than the reference voltage value, resulting in an erroneous detection.

The present disclosure was made to solve the problems, and is intended to provide an assembled battery testing method which can more accurately detect thermal propagation occurring in an assembled battery in an earlier stage than traditional methods.

In order to achieve the objective, an assembled battery testing method disclosed herein is provided.

The assembled battery testing method disclosed herein (hereinafter, also referred to as the "testing method") is to test thermal propagation occurring in an assembled battery including multiple single batteries arranged adjacent to each other along a predetermined alignment direction. The testing method includes: measuring voltages of the single batteries; calculating a reference voltage value Vs based on the voltages of the single batteries; and testing the thermal propagation based on the reference voltage value Vs and the voltages of the single batteries. In the testing of the testing method disclosed herein, if a first voltage difference (Vs - V₁) between a voltage V₁ of a predetermined first single battery and the reference voltage value Vs is a first threshold value V_{T1} or more, and a second voltage difference (Vs - V₂) between a voltage V₂ of a second single battery adjacent to the first single battery and the reference voltage value Vs is a second threshold value V_{T2} or more, it is determined that the thermal propagation is occurring in the single batteries.

In the testing method disclosed herein, the reference voltage value Vs is a value calculated based on the voltages of the single batteries. In the testing method disclosed herein, absolute evaluation of comparing with a reference voltage value fixed to a predetermined value (e.g., around 0 V) is not performed. That is, in the testing method disclosed herein, relative evaluation of comparing between the reference voltage value Vs calculated based on current voltages of the single batteries and the voltages of the single batteries is performed. The testing method allows detection of a single battery having an abnormal voltage drop compared with other single batteries, and detection of whether or not thermal propagation is occurring around the single battery. Therefore, unlike traditional technology that fixes the reference voltage value to around 0 V, thermal propagation occurring can be detected before a voltage of a specific single battery drops to around 0 V. Furthermore, the reference voltage value Vs in the technology disclosed herein is calculated based on the voltages of the single batteries which vary with the charging/discharging reaction. This also allows a reduction in erroneous detection caused by the changes in voltage with a charging/discharging reaction.

In a preferred aspect of the testing method disclosed herein, the reference voltage value Vs is an average voltage Vₐᵥₑ of the single batteries. This allows more accurate detection of thermal propagation occurring.

In a preferred aspect of the testing method disclosed herein, the reference voltage value Vs is an average voltage Vₐᵥₑ₍ₙ₋₂₎ of the other single batteries excluding the first single battery and the second single battery from the single batteries. This allows more accurate detection of occurrence of the thermal propagation occurring.

In a preferred aspect of the testing method disclosed herein, the reference voltage value Vs is a maximum voltage Vₘₐₓ of the single batteries. This allows detection of thermal propagation in an earlier stage.

In the testing method disclosed herein, in the testing, if the first voltage difference (Vs - V₁) is the first threshold value V_{T1} or more, whether or not the second voltage difference (Vs - V₂) is the second threshold value V_{T2} or more is continuously determined during a testing time set in advance. This allows more accurate detection of occurrence of the thermal propagation occurring. The testing time is, for example, set preferably in a range of 15 seconds to 450 seconds.

In a preferred aspect of the testing method disclosed herein, in the testing, if the voltage V₁ of the first single battery and the voltage V₂ of the second single battery are a predetermined second reference voltage value V_{S2} or less, it is determined that the thermal propagation is occurring in the single batteries. In this aspect, the testing method further includes testing of thermal propagation based on absolute evaluation using the second reference voltage value V_{S2} which is a fixed value set in advance. This allows more reliable detection of thermal propagation. In this case, the second reference voltage value V_{S2} is set to preferably 1 V or less.

### BRIEF DESCRIPTION OF THE DRAWINGS

[Fig. 1] Fig. 1 is a perspective view schematically illustrating an example of a structure of an assembled battery.
[Fig. 2] Fig. 2 is a perspective view schematically illustrating a single battery in Fig. 1.
[Fig. 3] Fig. 3 is a flowchart illustrating a testing method according to an embodiment.
[Fig. 4] Fig. 4 is a schematic view illustrating calculation of a reference voltage value Vs in the embodiment.
[Fig. 5] Fig. 5 is a schematic view illustrating calculation of a reference voltage value Vs in another embodiment.
[Fig. 6] Fig. 6 is a schematic view illustrating calculation of a reference voltage value Vs in another embodiment.

### DETAILED DESCRIPTION

The following describes embodiments of the technology disclosed herein. The matters necessary for executing the technology disclosed herein, except for matters specifically herein referred to (e.g., the detailed structure and manufacturing processes of the assembled battery) can be grasped as design matters of those skilled in the art based on the related art in the preset field. The technology disclosed herein can be executed based on the contents disclosed herein and the technical knowledge in the present field. The expression "A to B" indicating herein a range means A or more to B or less, and also encompasses the meaning of "preferably more than A" and "preferably less than B."

The "secondary battery" herein generally refers to an electricity storage device which causes a charging/discharging reaction by movement of charge carriers between a pair or electrodes (a positive electrode and a negative electrode) via an electrolyte. The "secondary battery" herein encompasses so-called secondary batteries such as a lithium-ion secondary battery, a nickel hydride battery and a nickel cadmium battery, and capacitors such as an electric double-layer capacitor.

An embodiment of the testing method disclosed herein will be described below. The testing method is a method of testing thermal propagation occurring in an assembled battery. The following describes an example of the structure of the assembled battery which is a testing target, and then describes specific testing procedures.

### 1. Structure of Assembled Battery

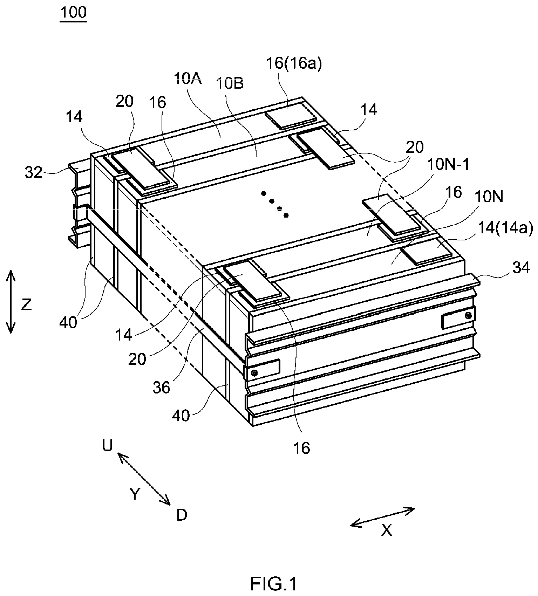

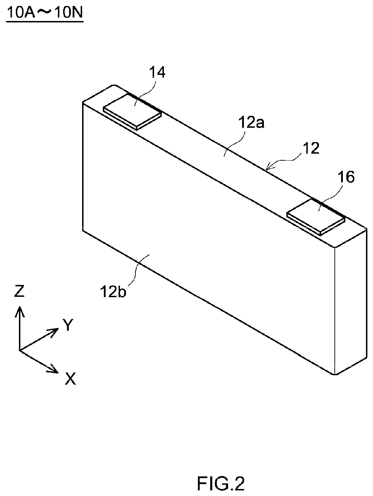

Fig. 1 is a perspective view schematically illustrating an example of a structure of an assembled battery. Fig. 2 is a perspective view schematically illustrating a single battery in Fig. 1. In Figs. 1 and 2, the reference sign X indicates "the width direction (of a single battery)," the reference sign Y indicates "the alignment direction (of a single battery)," and the reference sign Z indicates "the height direction (of a single battery)." In the alignment direction Y, U indicates an "upstream side," and D indicates a "downstream side." These directions are defined for convenience of explanation and are not intended to limit the technology disclosed herein.

An assembled battery 100 shown in Fig. 1 includes a plurality of (N) single batteries 10A to 10N. As shown in Fig. 2, each of the single batteries 10A to 10N includes a battery case 12 which is a flat square container. The battery case 12 is made of a metal material having predetermined rigidity such as aluminum. Although not shown in the drawings, the battery case 12 contains an electrode body where charging/discharging reaction occurs and an electrolyte therein. A positive electrode terminal 14 and a negative electrode terminal 16 are attached to the upper surface 12a of the battery case 12. Although not shown in the drawings, the positive electrode terminal 14 is electrically connected to a positive electrode of the electrode body inside the battery case 12. The negative electrode terminal 16 is electrically connected to a negative electrode of the electrode body inside the battery case 12.

As shown in Fig. 1, in the assembled battery 100, multiple single batteries 10A to 10N are arranged adjacent to each other along the predetermined alignment direction Y. The single batteries 10A to 10N aligned are electrically connected to each other via connection members 20. Specifically, the single batteries 10A to 10N are arranged so that their long side surfaces 12b (see Fig. 2) of the respective battery cases 12 face each other. At this time, the single batteries 10A to 10N are arranged such that the positive electrode terminal 14 of one of the adjacent single batteries comes close to the negative electrode terminal 16 of the other single battery. The positive electrode terminal 14 of one single battery is electrically connected to the negative electrode terminal 16 of the other single battery via a connection member 20. The negative electrode terminal 16 of the single battery 10A arranged at the upstream U end in the alignment direction Y is not connected to the adjacent single battery 10B. The negative electrode terminal 16 of the single battery 10A is a negative electrode output terminal 16a, which is connected to an external device (e.g., vehicle motor). Similarly, the positive electrode terminal 14 of the single battery 10N arranged at the downstream D end in the alignment direction Y is not connected to the adjacent single battery 10N-1. The positive electrode terminal 14 of this single battery 10N is a positive electrode output terminal 14a, which is connected to an external device.

In the assembled battery 100, multiple single batteries 10A to 10N are bonded along the alignment direction Y. Specifically, a pair of binding plates 32 and 34 are arranged on both outer sides of the assembled battery 100 in the alignment direction X. With the single batteries 10A to 10N sandwiched between the binding plates 32 and 34 in pair, the binding plates 32 and 34 are crosslinked with a crosslinking member 36. This binds the single batteries 10A to 10N along the alignment direction Y. In the assembled battery 100 shown in Fig. 1, a rectangular buffer plate 40 is arranged between adjacent single batteries. This allows uniform binding pressure to be applied to the long side surfaces 12b (see Fig. 2) of the battery cases 12.

### 2. Assembled Battery Testing Method

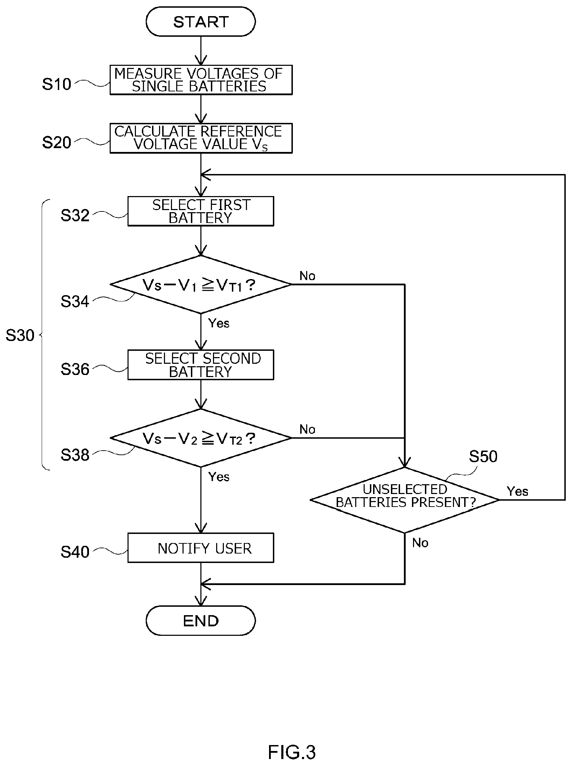

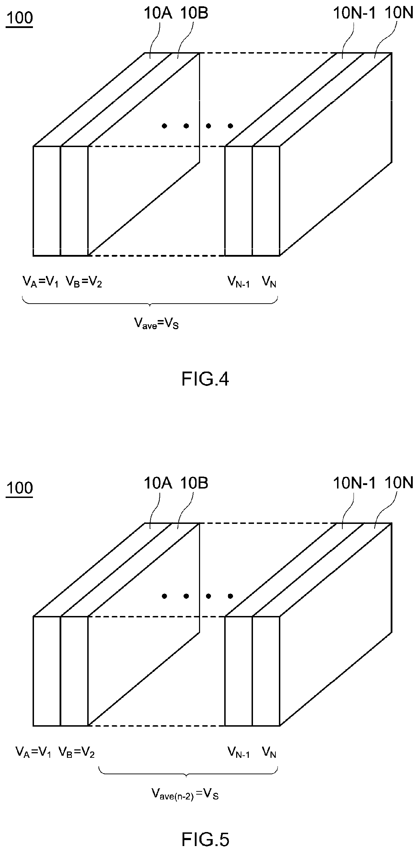

Next, the assembled battery testing method according to the present embodiment, targeted for the assembled battery 100 with the configuration described above will be described. Fig. 3 is a flowchart illustrating a testing method according to the present embodiment. Fig. 4 is a schematic view illustrating calculation of a reference voltage value Vs in the present embodiment.

The testing method according to the present embodiment includes voltage measurement, reference voltage calculation, and testing. Each process will be described below.

### (1) Voltage Measurement

In step S10 of Fig. 3, voltage measurement of measuring voltages V_{A} to V_{N} of multiple single batteries 10A to 10N is performed. A means for measuring the voltages V_{A} to V_{N} of the single batteries 10A to 10N is not particularly limited, and known means can be employed without particular limitations.

### (2) Reference Voltage Calculation

In step S20, reference voltage calculation of calculating a reference voltage value Vs is performed. As mentioned above, the "reference voltage value" herein means a voltage value to be a determination criteria for determining whether or not the single battery is generating heat. In the testing method according to the present embodiment, a value calculated based on the voltages V_{A} to V_{N} of the single batteries 10_{A} to 10_{N} constituting the assembled battery 100 is employed as the reference voltage value Vs, instead of a constant value set in advance. As described in detail below, the use of the reference voltage value Vs based on the voltages of the single batteries allows detection of a single battery which has an abnormal voltage drop in an early stage compared with the other single batteries. As shown in Fig. 4, in the testing method according to the present embodiment, an average voltage Vₐᵥₑ of the single batteries 10A to 10N constituting the assembled battery 100 is employed as the reference voltage value Vs. A single battery with a large voltage difference from the average voltage Vₐᵥₑ can be regarded as having an abnormal voltage drop. A single battery rapidly generating heat due to internal short-circuit or the like usually causes steep voltage drop. In other words, a single battery with a large voltage difference from the reference voltage value Vs (average voltage Vₐᵥₑ) can be regarded as rapid generation of heat.

### (3) Testing

Next, in step S30, testing of thermal propagation is performed based on the reference voltage value Vs and the voltages V_{A} to V_{N} of the single batteries 10A to 10N. As shown in Fig. 3, the testing (step S30) in the present embodiment includes the following steps S32 to S38. The following describes the steps.

In the testing of the present embodiment, step S32 of selecting a first single battery to be a testing target among the single batteries 10A to 10N is performed. The first single battery to be a testing target can be arbitrarily selected without particular limitations. The following describes a case where a single battery 10A (see Fig. 1) arranged at an upstream U end in the alignment direction Y is selected as the first single battery as an example.

Then, in step S34, a first voltage difference (Vₛ - V₁) between the voltage V₁ of the first single battery (the voltage V_{A} of the single battery 10A) and the reference voltage value Vs (average voltage Vₐᵥₑ) is calculated. In step S34, whether or not the first voltage difference is a first threshold value V_{T1} or more (Vs - V₁ ≥ V_{T1}?) is further determined. The first threshold value V_{T1} set in step S34 is a value set in consideration of the amount of voltage drop in the secondary battery which has rapidly generated heat. The first threshold value V_{T1} is set, as appropriate, in consideration of the results of preliminary tests and the like. The first threshold value V_{T1} may be set in a range of 50 mV to 150 mV (e.g., 100 mV) although it does not limit the technology disclosed herein. In step S34, if the first voltage difference (V_{S} - V₁) is the first threshold value V_{T1} or more (YES), it is determined that rapid heat generation is occurring in the first single battery (single battery 10A). In this case, the process proceeds to step S36. On the other hand, in step S34, if the first voltage difference (Vs - V₁) is less than the first threshold value V_{T1} (NO), it is determined that rapid head generation is not occurring in the first single battery (single battery 10A). In this case, the process proceeds to step S50. The step S50 will be described in detail later.

Then, in step S36, a single battery adjacent to the first single battery is selected as a second single battery. In the present embodiment, a single battery adjacent to the first single battery on the downstream side D in the alignment direction X is selected as the second single battery, although it does not limit the technology disclosed herein. For example, when the single battery 10A in Fig. 1 is the first single battery, the single battery 10B adjacent to the downstream side D of the single battery 10A is selected as the second single battery.

Then, in step S38, a second voltage difference (Vₛ - V₂) between the voltage V₂ of the second single battery (the voltage V_{B} of the single battery 10B) and the reference voltage value Vs (average voltage Vₐᵥₑ) is calculated. In step S38, whether or not the second voltage difference is a second threshold value V_{T2} or more (Vs - V₂ ≥ V_{T2}?) is further determined. Similarly to the first threshold value VT1, the second threshold value V_{T2} is a value set in consideration of the amount of voltage drop in the secondary battery which has rapidly generated heat. In other words, the second threshold value V_{T2} is set, as appropriate, in consideration of the results of preliminary tests and the like. The second threshold value V_{T2} may be set to a value which is the same as or difference from the first threshold value VT₁. The second threshold value V_{T2} may also be set in a range of 50 mV to 150 mV (e.g., 100 mV) although it does not limit the technology disclosed herein.

In step S38, it is preferable that the determination of whether or not the second voltage difference (Vs - V₂) is the second threshold value V_{T2} or more is continuously performed during the testing time set in advance. This allows the time lag between heat generation occurred in the first single battery and the propagation of the heat to the second single battery to be taken into account. As a result, the thermal propagation can be detected more accurately. The testing time set in step S34 is not particularly limited, and can be set, as appropriate, considering the results of the preliminary tests measuring thermal transfer rate between single batteries. As an example, the testing time is set preferably in a range of 15 seconds to 450 seconds (e.g., 300 seconds).

In step S38, if the second voltage difference (Vs - V₂) is the second threshold value V_{T2} or more (YES), it is determined that rapid heat generation is occurring in both of the first single battery (the single battery 10A) and the second single battery (the single battery 10B). In other words, if YES in step S38, it is determined that the thermal propagation is occurring between the single batteries 10A and 10B. In this case, the process proceeds to step S40, a user is notified of the occurrence of the thermal propagation, and the testing for the thermal propagation is ended. A means for notifying the user of the occurrence of the thermal propagation is not particularly limited, and for example, visual indication (indication on a display), notification by voice and the like (notification by alarm), and the like can be employed without particular limitations.

On the other hand, if it is determined that rapid heat generation is not generated in the first single battery (step S34: NO), or it is determined that thermal propagation is not occurring between the first single battery and the second single battery (step S38: NO), the process proceeds to step S50 to check the presence of unselected batteries. Specifically, in step S50, whether or not a single battery (an unselected battery) which has not been selected as the testing target (first single battery) is present among the single batteries 10A to 10N constituting the assembled battery 100 is checked. If unselected batteries are present (YES), the testing process returns to step S32, and a first single battery is selected among the unselected batteries to test again. On the other hand, when no unselected battery is present (NO), it is determined that thermal propagation is not occurring in all the single batteries 10A to 10N constituting the assembled battery 100, and the testing process is ended.

As described above, in the testing method according to the present embodiment, when the first voltage difference (Vs - V₁) between the voltage V₁ of the first threshold value V_{T1} and the reference voltage value Vs is the first threshold value V_{T1} or more, and the second voltage difference (Vs - V₂) between the voltage V₂ of the second single battery adjacent to the first single battery and the reference voltage value Vs is the second threshold value V_{T2} or more, it is determined that the thermal propagation between the first single battery and the second single battery is occurring. In the testing method with such a configuration, relative evaluation of comparing the reference voltage value Vs based on the current voltages V_{A} to V_{N} of the single batteries 10A to 10N and the voltages V_{A} to V_{N} of the single batteries 10A to 10N is performed. This allows detection of a single battery having an abnormal voltage drop compared with other single batteries, and detection of whether or not thermal propagation is occurring around the single battery. In the testing method according to the present embodiment, thermal propagation occurring is detected at the time when abnormal voltage drop is confirmed. Therefore, the thermal propagation can be detected earlier than the case where the thermal propagation cannot be detected until the voltage drops to around 0 V. The reference voltage value Vs (the average voltage Vₐᵥₑ) in the present embodiment reflects changes in voltage of each single battery with charging/discharging. This also allows a reduction in erroneous detection caused by changes in voltage with a charging/discharging reaction.

### 3. Other Embodiments

An embodiment of the testing method disclosed herein was described above. The embodiment is not intended to limit the testing method disclosed herein, and various changes can be made.

### (1) Calculation of Reference Voltage Value Vs

In the embodiment, an average voltage Vₐᵥₑ is employed as the reference voltage value Vs. However, the reference voltage value Vs is not particularly limited as long as it does not impair effects of the technology disclosed herein, and a voltage value other than the average voltage Vₐᵥₑ can also be employed.

For example, as shown in Fig. 4, the average voltage Vₐᵥₑ employed in the embodiment includes voltages of single batteries to be testing targets (the voltage V₁ of the first single battery and the voltage V₂ of the second single battery). Thus, when the voltage V₁ of the first single battery and the voltage V₂ of the second single battery are significantly reduced, the reference voltage value Vs (the average voltage Vₐᵥₑ) may be a value lower than the normal voltage value. Accordingly, when an average voltage is employed as the reference voltage value Vs, it is suitable to calculate the average voltage Vₐᵥₑ₍ₙ₋₂₎ of the other single batteries excluding the first single battery and the second single battery from the multiple single batteries 10A to 10N constituting the assembled battery 100, as shown in Fig. 5. This allows more accurate detection of thermal propagation.

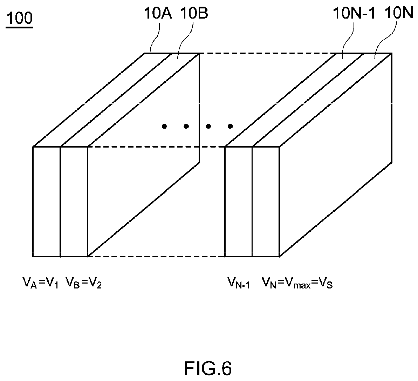

As the reference voltage value Vs, a voltage value other than the average voltage can also be employed. Another example of the reference voltage value Vs can be the maximum voltage Vₘₐₓ in the single batteries 10A to 10N constituting the assembled battery 100 (see Fig. 6). When the maximum voltage Vₘₐₓ is employed as the reference voltage value Vs, the voltage differences (Vs - V₁ and V_{S} - V₂) from the reference voltage value Vs become large. This makes it easier to detect a single battery with slightly reduced voltage in an early stage of heat generation. Although detailed description is omitted, the reference voltage value Vs may be the median value or mode value of the voltages V_{A} to V_{N} of the single batteries 10A to 10N, in addition to the average value and the maximum value mentioned above.

### (2) Selection of First Single Battery

In the testing method according to the embodiment, as shown in step S32 in Fig. 3, one single battery is selected as the first battery (testing target) from among multiple single batteries 10A to 10N, and whether or not thermal propagation is occurring around the first battery is tested. Then, if the thermal propagation is not occurring around the first battery, the testing process returns to step S32 through step S50, and a first single battery is again selected from among unselected batteries, and subjected to testing. However, the process of selecting the first single battery to be a testing target is not limited to the embodiment. For example, the reference voltage value Vs and the voltage differences (V_{S} - V_{A} to Vs - V_{N}) may be calculated for all voltages V_{A} to V_{N} of the single batteries 10A to 10N. Then, a process of regarding a single battery where the calculated voltage difference (Vs - V_{A} to Vs - V_{N}) is a first threshold value VT1 or more as the "first single battery" and testing whether or not the thermal propagation is occurring around the first single battery may also be employed.

### (3) Selection of Second Single Battery

In the testing method according to the embodiment, a single battery adjacent to the downstream side of the first single battery is regarded as a second single battery, and whether or not an abnormal voltage drop is occurring in the second single battery is determined to test the occurrence of the thermal propagation (see steps S36 and S38 in Fig. 3). However, the process of selecting the second single battery is not limited to the embodiment. For example, a pair of single batteries arranged on both sides of the first single battery may be both regarded as second single batteries. In this case, if at least one of the second single batteries in pair has an abnormal voltage drop, it can be determined that thermal propagation is occurring.

### (4) Setting of Second Reference Voltage Value V_{S2}

As mentioned above, the testing method disclosed herein is characterized in that relative evaluation of comparing the reference voltage value Vs calculated based on the voltages of the single batteries and the voltages of the single batteries is performed, and a single battery having an abnormal voltage drop is detected. However, such a characteristic does not negate the combination with absolute evaluation, which involves comparing with a reference voltage value fixed to a predetermined value. In the testing method disclosed herein, absolute evaluation where it is determined that thermal propagation is occurring when the voltage V₁ of the first single battery and the voltage V₂ of the second single battery are the predetermined second reference voltage value V_{S2} or less may be performed in addition to the relative evaluation of comparing with the first reference voltage value Vsi calculated based on the voltages of the single batteries. This allows more reliable detection of the occurrence of the thermal propagation even if all of the single batteries constituting the assembled battery have steep voltage drops, and the first reference voltage value V_{S1} largely decreases. The second reference voltage value V_{S2} may be a value set in consideration of the voltage value of the secondary battery which is rapidly generating heat. For example, the second reference voltage value V_{S2} can be set, as appropriate, in consideration of the results of the preliminary tests. The second reference voltage value V_{S2} is preferably 1 V or less, more preferably 0.5 V or less, particularly preferably 0.1 V or less (e.g., around 0 V), although it does not limit the technology disclosed herein.

## Claims

1. An assembled battery testing method of testing thermal propagation occurring in an assembled battery (100) including multiple single batteries (10A to 10N) arranged adjacent to each other along a predetermined alignment direction,
the method comprising:
measuring voltages of the single batteries (10A to 10N); **characterized in that**
calculating a reference voltage value Vs based on the voltages of the single batteries (10A to 10N); and
testing the thermal propagation based on the reference voltage value Vs and the voltages of the single batteries (10A to 10N), wherein
in the testing, if a first voltage difference (Vs - V₁) between a voltage V1 of a predetermined first single battery (10A) and the reference voltage value Vs is a first threshold value V_{T1} or more, and a second voltage difference (Vs - V₂) between a voltage V₂ of a second single battery (10B) adjacent to the first single battery (10A) and the reference voltage value Vs is a second threshold value V_{T2} or more, it is determined that the thermal propagation is occurring in the single batteries, and
in the testing, if the first voltage difference (Vs - V₁) is the first threshold value V_{T1} or more, whether or not the second voltage difference (Vs - V₂) is the second threshold value V_{T2} or more is continuously determined during a testing time set in advance.

2. The assembled battery testing method according to claim 1, wherein the reference voltage value Vs is an average voltage Vₐᵥₑ of the single batteries (10A to 10N).

3. The assembled battery testing method according to claim 1, wherein the reference voltage value Vs is an average voltage Vₐᵥₑ₍ₙ₋₂₎ of the other single batteries excluding the first single battery (10A) and the second single battery (10B) from the single batteries (10A to 10N).

4. The assembled battery testing method according to claim 1, wherein the reference voltage value Vs is a maximum voltage Vₘₐₓ of the single batteries (10A to 10N).

5. The assembled battery testing method according to any one of claims 1 to 4, wherein the testing time is set in a range of 15 seconds to 450 seconds.

6. The assembled battery testing method according to any one of claims 1 to 5, wherein in the testing, if the voltage V₁ of the first single battery (10A) and the voltage V₂ of the second single battery (10B) are a predetermined second reference voltage value V_{S2} or less, it is determined that the thermal propagation is occurring in the single batteries.

7. The assembled battery testing method according to claim 6, wherein the second reference voltage value V_{S2} is 1 V or less.

## Patentansprüche

1. Prüfverfahren für eine zusammengebaute Batterie zum Prüfen einer thermischen Ausbreitung, die in einer zusammengebauten Batterie (100) auftritt, die mehrere Einzelbatterien (10A bis 10N) umfasst, die entlang einer vorbestimmten Ausrichtungsrichtung nebeneinander angeordnet sind,
wobei das Verfahren umfasst:
Messen von Spannungen der Einzelbatterien (10A bis 10N);
**dadurch gekennzeichnet, dass**
ein Referenzspannungswerts V_{S} auf der Grundlage der Spannungen der Einzelbatterien (10A bis 10N) berechnet wird; und
die thermische Ausbreitung auf der Grundlage des Referenzspannungswerts V_{S} und der Spannungen der Einzelbatterien (10A bis 10N) geprüft wird, wobei
während des Prüfens, wenn eine erste Spannungsdifferenz (V_{S} - V₁) zwischen einer Spannung V₁ einer vorbestimmten ersten Einzelbatterie (10A) und dem Referenzspannungswert V_{S} ein erster Schwellenwert V_{T1} oder mehr ist, und eine zweite Spannungsdifferenz (V_{S} - V₂) zwischen einer Spannung V₂ einer zweiten Einzelbatterie (10B), die neben einer ersten Einzelbatterie (10A) angeordnet ist, und dem Referenzspannungswert V_{S} ein zweiter Schwellenwert V_{T2} oder mehr ist, festgestellt wird, dass die thermische Ausbreitung in den Einzelbatterien stattfindet, und
während des Prüfens, wenn die erste Spannungsdifferenz (V_{S} - V₁) der erste Schwellenwert V_{T1} oder mehr ist, während einer im Voraus festgelegten Prüfzeit kontinuierlich ermittelt wird, ob die zweite Spannungsdifferenz (V_{S} - V₂) der zweite Schwellenwert V_{T2} oder mehr ist oder nicht.

2. Prüfverfahren für eine zusammengebaute Batterie nach Anspruch 1, wobei der Referenzspannungswert V_{S} eine Durchschnittsspannung Vₐᵥₑ der Einzelbatterien (10A bis 10N) ist.

3. Prüfverfahren für eine zusammengebaute Batterie nach Anspruch 1, wobei der Referenzspannungswert V_{S} eine Durchschnittsspannung Vₐᵥₑ₍ₙ₋₂₎ der anderen Einzelbatterien ist, wobei die erste Einzelbatterie (10A) und die zweite Einzelbatterie (10B) von den Einzelbatterien (10A bis 10N) ausgeschlossen sind.

4. Prüfverfahren für eine zusammengebaute Batterie nach Anspruch 1, wobei der Referenzspannungswert V_{S} eine Maximalspannung Vₘₐₓ der Einzelbatterien (10A bis 10N) ist.

5. Prüfverfahren für eine zusammengebaute Batterie nach einem der Ansprüche 1 bis 4, wobei die Prüfzeit auf einen Bereich von 15 Sekunden bis 450 Sekunden eingestellt ist.

6. Prüfverfahren für eine zusammengebaute Batterie nach einem der Ansprüche 1 bis 5, wobei, während des Prüfens, wenn die Spannung V₁ der ersten Einzelbatterie (10A) und die Spannung V₂ der zweiten Einzelbatterie (10B) ein vorbestimmter zweiter Referenzspannungswert V_{S2} oder weniger sind, festgestellt wird, dass die thermische Ausbreitung in den Einzelbatterien stattfindet.

7. Prüfverfahren für eine zusammengebaute Batterie nach Anspruch 6, wobei der zweite Referenzspannungswert V_{S2} 1 V oder weniger ist.

## Revendications

1. Un procédé de test d'une batterie assemblée visant à tester la propagation thermique se produisant dans une batterie assemblée (100) comprenant plusieurs batteries individuelles (10A à 10N) disposées les unes à côté des autres selon une direction d'alignement prédéterminée,
le procédé comprenant :
la mesure des tensions des batteries individuelles (10A à 10N) ; **caractérisée en ce qu'**elle comprend :
calculer une valeur de tension de référence V_{S} sur la base des tensions des batteries individuelles (10A à 10N) ; et
tester la propagation thermique sur la base de la valeur de tension de référence V_{S} et des tensions des batteries individuelles (10A à 10N), dans lequel
lors du test, si une première différence de tension (Vs - V₁) entre une tension V₁ d'une première batterie individuelle prédéterminée (10A) et la valeur de tension de référence V_{S} est égale ou supérieure à une première valeur seuil V_{T1}, et si une deuxième différence de tension (V_{S} - V₂) entre une tension V₂ d'une deuxième batterie individuelle (10B) adjacente à la première batterie individuelle (10A) et la valeur de tension de référence V_{S} est égale ou supérieure à une deuxième valeur seuil V_{T2}, il est déterminé qu'une propagation thermique se produit dans les batteries individuelles, et
lors du test, si la première différence de tension (Vs - V₁) est égale ou supérieure à la première valeur seuil V_{T1}, on détermine en continu, pendant une durée de test prédéfinie, si la deuxième différence de tension (V_{S} - V₂) est égale ou supérieure à la deuxième valeur seuil V_{T2}.

2. Le procédé de test d'une batterie assemblée selon la revendication 1, dans lequel la valeur de tension de référence Vs correspond à la tension moyenne Vₐᵥₑ des batteries individuelles (10A à 10N).

3. Le procédé de test d'une batterie assemblée selon la revendication 1, dans lequel la valeur de tension de référence Vs correspond à la tension moyenne Vₐᵥₑ₍ₙ₋₂₎ des autres batteries individuelles, à l'exclusion de la première batterie individuelle (10A) et de la deuxième batterie individuelle (10B) parmi les batteries individuelles (10A à 10N).

4. Le procédé de test d'une batterie assemblée selon la revendication 1, dans lequel la valeur de tension de référence Vs correspond à la tension maximale Vₘₐₓ des batteries individuelles (10A à 10N).

5. Le procédé de test d'une batterie assemblée selon l'une quelconque des revendications 1 à 4, dans lequel la durée du test est fixée dans une plage de 15 secondes à 450 secondes.

6. Le procédé de test d'une batterie assemblée selon l'une quelconque des revendications 1 à 5, dans lequel, lors du test, si la tension V₁ de la première batterie individuelle (10A) et la tension V₂ de la deuxième batterie individuelle (10B) sont égales ou inférieures à une deuxième valeur de tension de référence prédéterminée V_{S2}, on détermine qu'une propagation thermique est en cours dans les batteries individuelles.

7. Le procédé de test d'une batterie assemblée selon la revendication 6, dans lequel la deuxième valeur de tension de référence V_{S2} est égale ou inférieure à 1 V.
